# EUROPEAN PATENT SPECIFICATION

(11) **EP 0 878 908 B1**
(45) Date of publication and mention of the grant of the patent: **05.12.2001**
(21) Application number: 97307632.6
(22) Date of filing: 29.09.1997
(51) Int. Cl.: H03K 5/151, G11C 7/00

(54) **Semiconductor device using complementary clock and signal input state detection circuit used for the same**
Halbleitervorrichtung mit komplementärem Takt und Schaltung zur Detektion des Eingangssignalzustandes dafür
Dispositif semi-conducteur utilisant une horloge complémentaire et circuit de détection de l'état d'un signal d'entrée pour le même

(30) Priority: 21.04.1997 JP 10337597
(43) Date of publication of application: 18.11.1998
(73) Proprietor: FUJITSU LIMITED, Kawasaki-shi, Kanagawa 211-8588 (JP)
(72) Inventor: Taguchi, Masao, Nakahara-ku, Kawasaki-shi, Kanagawa 211 (JP); Tomita, Hiroyoshi, Nakahara-ku, Kawasaki-shi, Kanagawa 211 (JP); Matsuzaki, Yasurou, Nakahara-ku, Kawasaki-shi, Kanagawa 211 (JP)
(74) Representative: Stebbing, Timothy Charles

(56) References cited:
- EP-A- 0 647 898
- US-A- 4 982 116
- US-A- 5 101 127
- PATENT ABSTRACTS OF JAPAN vol. 014, no. 444 (E-0982), 21 September 1990 & JP 02 174421 A (NEC CORP), 5 July 1990
- PATENT ABSTRACTS OF JAPAN vol. 013, no. 437 (E-826), 29 September 1989 & JP 01 164142 A (FUJITSU LTD), 28 June 1989
- PATENT ABSTRACTS OF JAPAN vol. 010, no. 011 (E-374), 17 January 1986 & JP 60 173949 A (FUJITSU KK), 7 September 1985

## Description

### BACKGROUND OF THE INVENTION

### 1. Field of the Invention

The present invention relates to a semiconductor device comprising an internal clock generating circuit for receiving an external clock and generating an internal clock, and more in particular to a semiconductor device comprising an internal clock generating circuit for generating a first internal clock (CLK1) in phase with an external clock and a second internal clock 180° out of phase (shifted by one-half of a phase) from the external clock.

### 2. Description of the Related Art

In a system comprising a combination of a plurality of semiconductor devices, it is a common practice to synchronize the operations of the various parts with a clock. For this reason, semiconductor devices other than the one which generates and outputs an original clock include an internal clock generating circuit which receives the clock output from other semiconductor devices and generates an internal clock used for the internal parts thereof. A description herein will be made of a synchronized dynamic random access memory (SDRAM) as an example which performs signal input and output operations with external sources and an internal operation in synchronism with a clock. The present invention, however, is not limited to the SDRAM.

In recent years, a demand has increased for an improved data transfer rate of the SDRAM, and the clock frequency has greatly increased. With an increased clock frequency, however, the problem of the signal deterioration, etc. is posed. As described above, the data signal changes in accordance with the period of the clock, and the frequency of the data signal is one half that of the clock. In view of this, a DDR (double data rate) technique has been proposed, in which the data signal is set to the same frequency as the clock and is retrieved in synchronism with both the leading and trailing edges of the clock.

In the DDR technique, the ideal phase difference between the leading and trailing edges of a clock CLK is 180°. The external clock actually retrieved, however, often has a phase difference other than 180° between the leading and trailing edges due to the load of the signal line, etc. Also, the characteristics of the internal clock generating circuit frequently causes the internal clock to have a phase difference other than 180° between the leading and trailing edges thereof. The resulting problem is that if a data signal is retrieved or the internal circuit is operated in synchronism with the leading and trailing edges of the internal clock, the time margin for normal operation cannot be satisfied.

In employing the DDR technique, one solution to the above-mentioned problem would be for the transmitting end of the signal to output a first clock CLK and a second clock /CLK 180° out of phase in complementary relation with each other and for the receiving end of the signal to retrieve the signal in synchronism with the leading edges of CLK and /CLK. Another solution to the problem would be to generate a second internal clock exactly 180° out of phase with the external clock CLK in the SDRAM using the delay locked loop (DLL) or the like technique from the external clock CLK.

A SDRAM could thus be fabricated incorporating one of the two types of internal clock generating circuits (clock input circuits) depending on the technique used for the system on which it is mounted. In other words, two types of SDRAM could be fabricated, one exclusively using a complementary clock, and the other for exclusively generating a 180° clock internally.

Nevertheless, analogous semiconductors having two different specifications would be fabricated at a higher cost due to a lower production efficiency and an inefficient inventory control. The manufacturer which produced a system using such a device would also suffer from an increased cost due to an increased stockpile. Thus, a device is desirable which can be used for both a system using a complementary clock and a system which generates a 180 phase clock internally.

EP-A-0 647 898 discloses an apparatus for activating a device dependent on the level of the input signal. For example, a logic device is activated when the voltage of the input signal falls outside the voltage range which represents a logical HIGH and the voltage range which represents a logical LOW.

US-A-4 982 116 discloses a clock selection circuit which disables an internal clock generator if an external clock signal is provided at an input port. A single clock input circuit is provided and a single internal clock is generated.

### SUMMARY OF THE INVENTION.

The present invention is intended to solve the above problem, and the object thereof is to provide a semiconductor device usable for both a system using a complementary clock and a system generating a 180° phase internally at the same time.

According to the present invention, there is provided a semiconductor device having a first clock terminal and a second clock terminal, comprising:
a first clock input circuit connected with the first clock terminal and producing a first internal clock; a second clock input circuit connected with the second clock terminal and producing a second internal clock complementary with the first internal clock when an external clock signal is applied to the second clock terminal; a 1/2 phase shift circuit for generating a 1/2 phase shift signal 180° out of phase with said first internal clock; a detection circuit for judging whether said external clock signal is applied to said second clock terminal; and a switch connected to an output of the second clock input circuit and an output of the 1/2 phase shift circuit, and selecting one of the second internal clock and the 1/2 phase shift signal in response to a detection signal from the detection circuit.

In the semiconductor device according to this invention, the signal generated from the second external clock signal (second external clock) is produced as a second internal clock when the second external clock is input thereto, and a 1/2 phase shift signal 180° out of phase with the first internal clock is produced as a second internal clock when the second external clock is not input thereto. The semiconductor device according to this invention, therefore, can meet the requirements of the two types of system at the same time.

When the 1/2 phase shift signal is output as the second internal clock in the absence of the second external clock applied thereto, the second clock input circuit need not be operated. The second clock input circuit, therefore, is desirably turned off to save power in such a case.

Also, as long as the second external clock is input, the 1/2 phase shift circuit (1/2 phase clock generating circuit) need not be operated. Therefore, the 1/2 phase clock generating circuit is desirably turned off to save power. In such a case, the 1/2 phase clock generating circuit, if the first internal clock is not being supplied thereto, is substantially turned off.

The 1/2 phase clock generating circuit is made up of a PLL circuit or a delay locked loop (DLL) having a delay line of which the delay amount is selectable in predetermined units of delay.

Various methods are conceivable for realizing the detection circuit (/CLK state detection circuit). In an example configuration, a switching edge of the second clock is detected, so that upon detection of the switching of the second clock, application of the second external clock is judged. In another possible configuration, the voltage of an input pin supplied with the second external clock is fixed to Vcc or Vss, or upon detection that the input pin is open, the absence of the second external clock input is judged. The frequency of the second clock is so high that the switching edge thereof is difficult to detect. Therefore, the /CLK state detection circuit preferably includes a frequency divider to detect the switching edge of the second clock with a longer period than that of the second external clock.

The /CLK state detection circuit is for detecting whether or not the second external clock is input within a predetermined length of time after power is switched on and for subsequently maintaining the judgement, or normally detects the presence or absence of an input of the second external clock.

### BRIEF DESCRIPTION OF THE DRAWINGS

The present invention will be more clearly understood from the description as set below with reference to the accompanying drawings, wherein:
Fig. 1 is a diagram showing a general configuration of a SDRAM;
Figs. 2A and 2B are diagrams showing the data input operation of the SDRAM;
Figs. 3A and 3B are diagrams showing a conventional circuit for generating a complementary clock;
Fig. 4 is a diagram showing a basic configuration of the present invention;
Fig. 5 is a diagram showing a configuration of an internal clock generating circuit of a SDRAM according to a first embodiment of the invention;
Fig. 6 is a diagram showing a configuration of a 1/2 phase shift DLL circuit according to the first embodiment;
Fig 7 is a diagram showing an example configuration of a delay circuit and a delay control circuit according to the first embodiment;
Fig. 8 is a diagram showing a configuration of a /CLK state detection circuit according to the first embodiment;
Fig. 9 is a diagram showing a control signal for the /CLK state detection circuit;
Fig. 10 is a time chart showing the operation of the /CLK state detection circuit according to the first embodiment;
Fig. 11 is a time chart showing the operation of the /CLK state detection circuit according to the first embodiment;
Fig. 12 is a diagram showing a configuration of an input circuit according to the first embodiment;
Fig. 13 is a diagram showing a configuration of an internal clock generating circuit of a SDRAM according to a second embodiment of the present invention;
Fig. 14 is a diagram showing a configuration of a /CLK state detection circuit according to the second embodiment;
Fig. 15 is a time chart showing the operation of the /CLK state detection circuit according to the second embodiment;
Fig. 16 is a time chart showing the operation of the /CLK state detection circuit according to the second embodiment;
Fig. 17 is a diagram showing a configuration of an internal clock generating circuit of a SDRAM according to a third embodiment of the invention;
Fig. 18 is a diagram showing a configuration of an internal clock generating circuit of a SDRAM according to a fourth embodiment of the invention;
Fig. 19 is a diagram showing a configuration of an internal clock generating circuit of a SDRAM according to a fifth embodiment of the invention; and
Fig. 20 is a diagram showing a configuration of a /CLK state detection circuit according to the fifth embodiment.

### DESCRIPTION OF THE PREFERRED EMBODIMENTS

Before proceeding to a detailed description of the preferred embodiments of the present invention, a prior art internal clock generating circuit of a synchronous dynamic random access memory (SDRAM) will be described with reference to the accompanying drawings relating thereto for a clearer understanding of the differences between the prior art and the present invention.

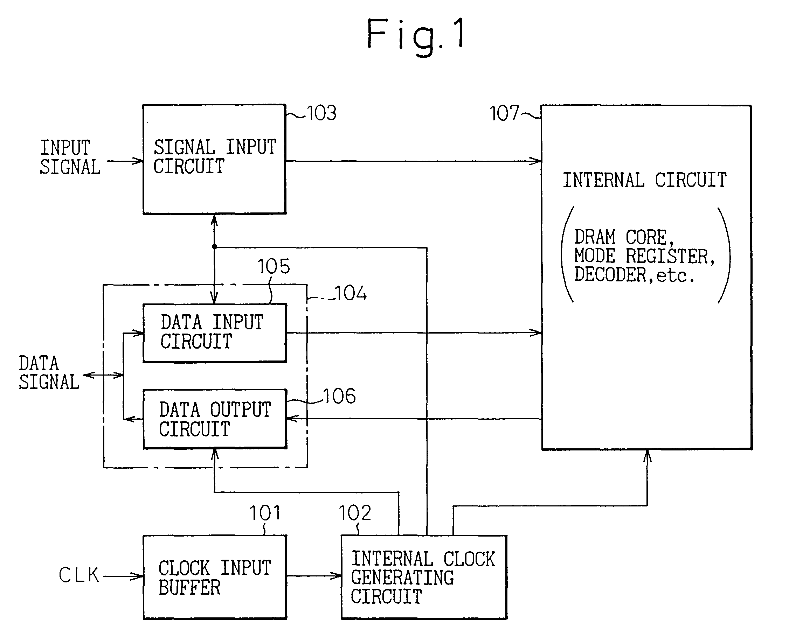

Fig. 1 is a diagram showing a general configuration of a SDRAM. The SDRAM increases the speed of the input/output operation of the data signal by pipelining the internal operation in synchronism with a clock. As a result, as shown in Fig. 1, the SDRAM includes an internal clock generating circuit 102 for generating an internal clock from an external clock applied to a clock buffer 101. The internal clock generated by the internal clock generating circuit 102 is applied to an internal circuit 107 having a DRAM core, a mode register, a decoder, etc., a data input/output buffer 104 having a data input circuit 105 and a data output circuit 106, and a signal input circuit 103 impressed with signals other than the data signal. In this way, these component parts are controlled to operate in synchronism with each other.

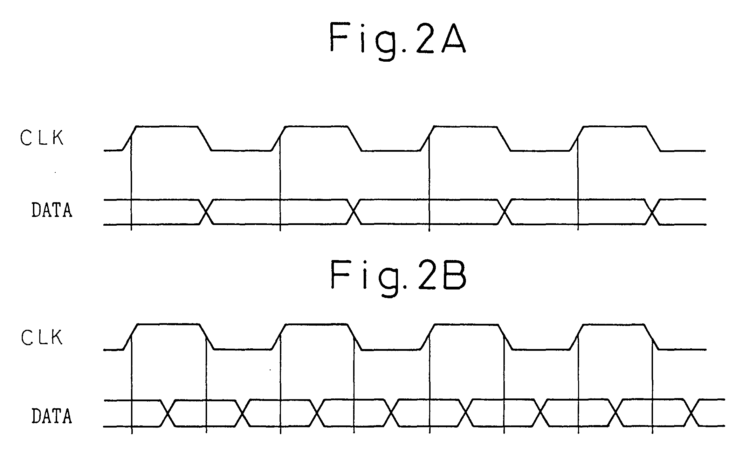

Figs. 2A and 2B are diagrams showing the input operation of the data signal for the SDRAM. As shown in Fig. 2A, the data signal to be written in the SDRAM is applied in synchronism with an external clock CLK. The data input circuit 105 latches the data signal in synchronism with the internal clock supplied thereto from the internal clock generating circuit 102 and retrieves the signal into the SDRAM. As shown, the data signal undergoes a change in synchronism with the trailing edge of the external clock CLK. Therefore, the internal clock generating circuit 102 applies the same internal clock as the external clock CLK to the data input circuit 105, which in turn retrieves the input data in synchronism with the leading edge of the external clock CLK. In other words, the data signal undergoes a change for each period of the external clock CLK. This is also the case with the data signal output from the SDRAM, which undergoes a change for each period of the external clock CLK.

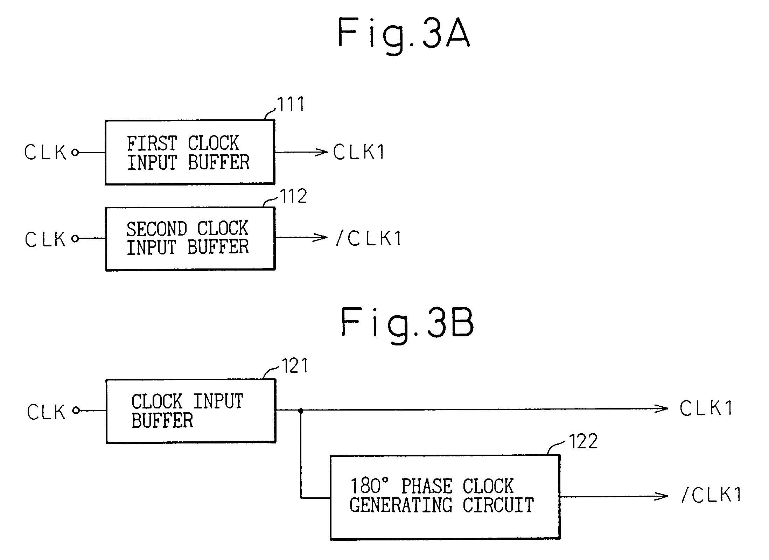

In recent years, a DDR (double data rate) technique has been proposed, in which a data signal is set as a signal having the same frequency as a clock and retrieved in synchronism with both the leading edge and the trailing edge of the clock. Fig. 2B is a diagram showing the data signal input operation according to the DDR technique. As shown in Fig. 2B, the DDR technique secures an ideal phase difference of 180° between the leading edge and the trailing edge of the clock CLK. In a method employing the DDR technique, therefore, the transmitting end of the signal outputs a first clock CLK and a second clock /CLK 180° out of phase in complementary relation with each other, while the receiving end of the signal retrieves the signal in synchronism with the leading edges of the CLK and /CLK signals. In such a case, as shown in Fig. 3A, the SDRAM generates a first internal clock CLK1 in response to a first clock CLK received at a first clock buffer 111, and generates a first internal clock /CLK1 in response to a second clock /CLK received at a second clock buffer 112. Another method which can be employed consists in generating a second internal clock exactly 180° out of phase with the external clock CLK within the SDRAM using the technique such as the delay locked loop (DLL). In this case, as shown in Fig. 3B, the first clock CLK is received by the clock buffer 121 thereby to generate a first internal clock CLK1, and a 180° phase clock generating circuit 122 generates a second internal clock /CLK1 180° out of phase.

A SDRAM is thus fabricated incorporating one of the internal clock generating circuits (clock input circuits) shown in (1) and (2) of Fig. 3 depending on the technique employed for the system on which the SDRAM is mounted. Specifically, two types of SDRAM are fabricated, one exclusively using a complementary clock, and the other exclusively generating a 180° phase clock internally.

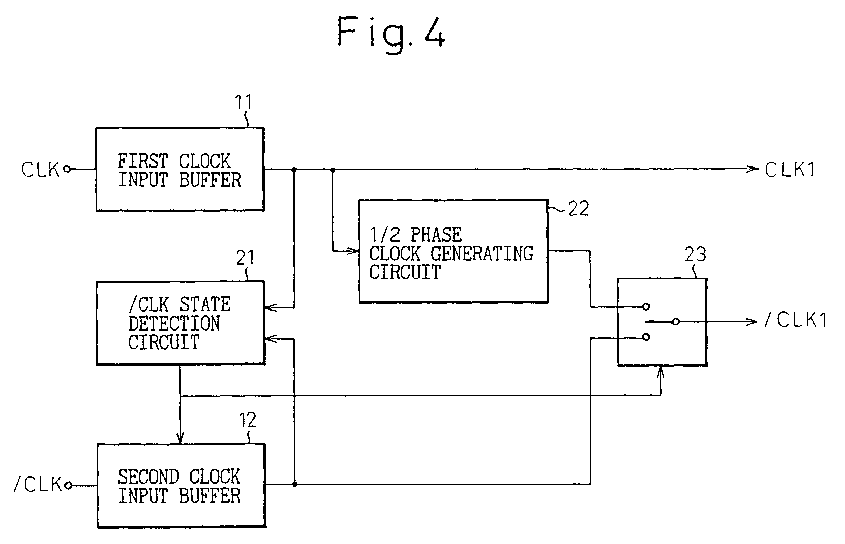

Fig. 4 is a diagram showing a basic configuration of the present invention. As shown in Fig. 4, a semiconductor device according to this invention comprises means for generating a first internal clock CLK1 and a second internal clock /CLK1 complementary with each other from an external clock, a first clock input circuit (buffer) supplied with the first external clock CLK for producing the first internal clock CLK1, a second clock input circuit (buffer) 12 supplied with a second external clock /CLK complementary with the first external clock CLK for producing a second clock, a 1/2 phase clock generating circuit 22 for generating a 1/2 phase shift signal having a phase 180° out of phase with the first internal clock CLK1, a /CLK state detection circuit 21 for judging whether the second external clock /CLK is applied to the second clock input buffer 12, and a switch 23 for producing the second clock as the second internal clock /CLK1 in the presence of the second external clock /CLK applied thereto and for producing the 1/2 phase shift signal as the second internal clock /CLK1 in the absence of the second external clock /CLK applied thereto in accordance with the result of judgement at the /CLK state detection circuit 21.

In the semiconductor device according to this invention, as long as the second external clock /CLK is applied, the signal generated from the second external clock /CLK is produced as a second internal clock, and as long as the second external clock /CLK is not applied, a 1/2 phase shift signal 180° out of phase generated from the first internal clock CLK1 is output as the second internal clock. Thus, a semiconductor device according to this invention can meet the requirements of both types of system described above.

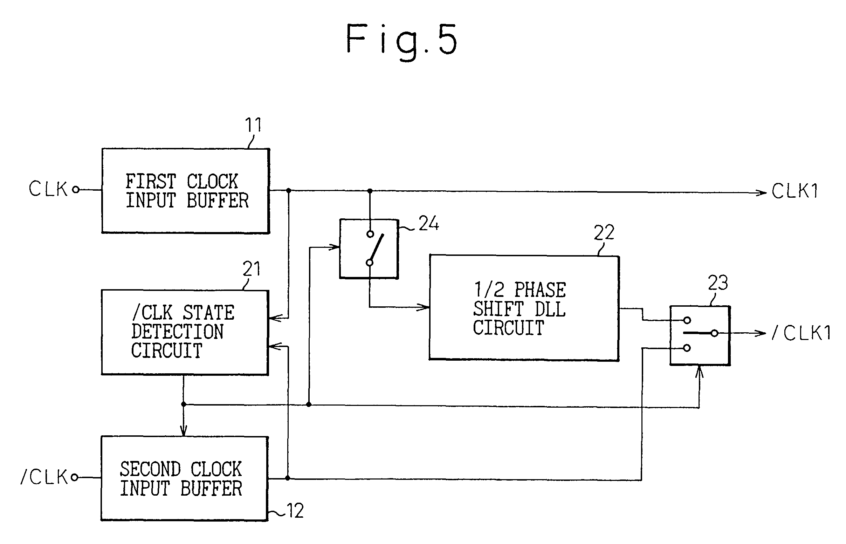

Fig. 5 is a diagram showing a configuration of an internal clock generating circuit of a semiconductor device according to a first embodiment of the invention. As shown, the circuit of the first embodiment further comprises a switch 24 in addition to the configuration of Fig. 4, and realizes the 1/2 phase clock generating circuit of Fig. 4 as a DLL circuit. Each part will be explained below.

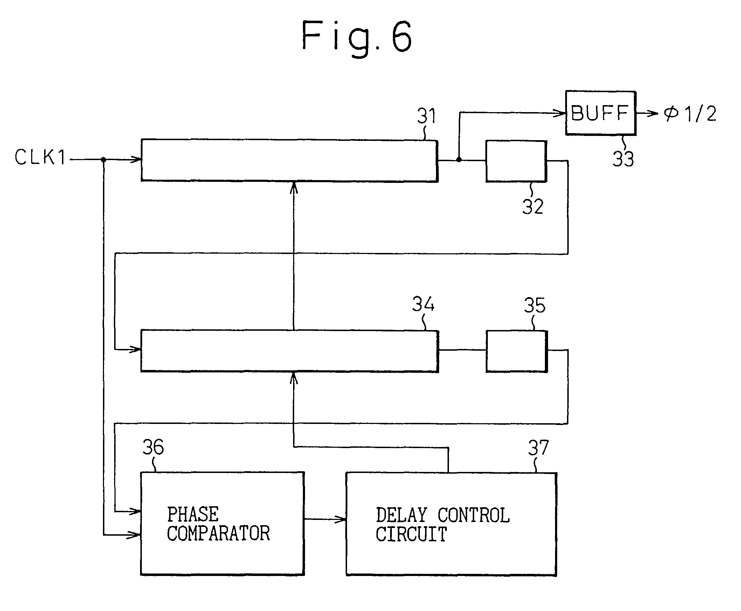

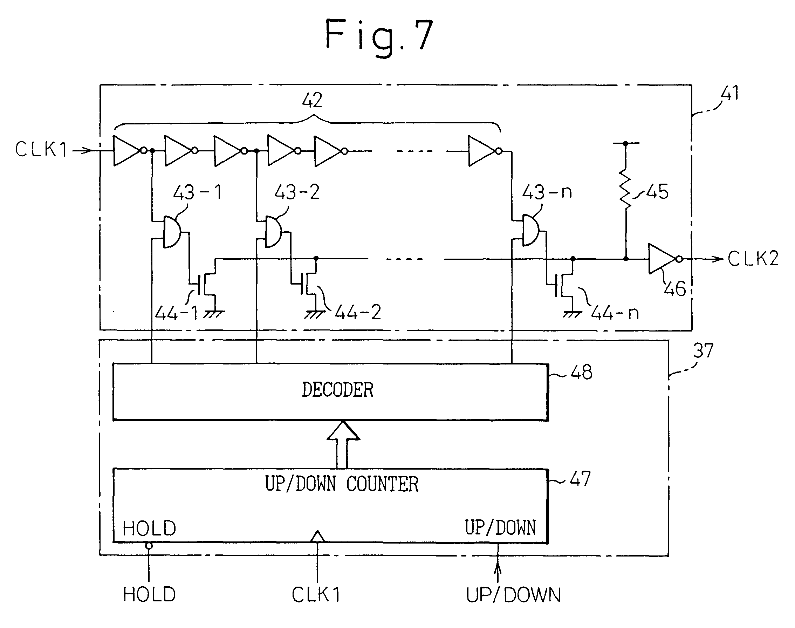

Fig. 6 is a diagram showing a general circuit configuration of the 1/2 phase shift DLL circuit 22. As shown in Fig. 6, the 1/2 phase shift DLL circuit 22 includes first and second delay circuits 31, 34 having the same configuration, buffer circuits 32, 33, 35 having the same configuration, a phase comparator circuit 36, and a delay control circuit 37 for adjusting the amount of delay of the delay circuits 31, 34 on the basis of the judgement of the phase comparator circuit 36. The delay circuits 31, 34 and the delay control circuit 37 have a circuit configuration as shown in Fig. 7. First, the delay circuit and the delay control circuit will be explained.

In Fig. 7, only one of the delay circuits 31, 34 is designated by reference numeral 41, and the other delay circuit is not shown. The delay circuits 31 and 34 have the same configuration, and are adjusted to have the same amount of delay by the control signal from the delay control circuit 37. As shown, the delay circuit 41 includes an inverter string 42 having a plurality of inverters connected in series, an AND gate string including a plurality of AND gates 43-1, 43-2,..., 43-n adapted in such a manner that one of the inputs thereof receives the output of each two stages of the inverter string 42, a transistor string including N-channel transistors 44-1, 44-2, ..., 44-n with the gates thereof supplied with the output of each AND gate, the sources grounded and the drains connected in common, a resistor 45 inserted between a signal line connected with the drains of the N-channel transistors in common and the high-potential side of the power supply, and a buffer 46 with an input terminal thereof connected to the signal line for producing an internal clock CLK2. The delay control circuit 37 includes an up-down counter 47 for switching between count-up and count-down in accordance with the result of comparison at the phase comparator circuit 36 and a decoder 48 for decoding the output of the up/down counter 47. The up/down counter 47 reduces a HOLD signal to L as required and thereby is capable of holding the count value. When the HOLD signal is H and the first internal clock CLK1 rises, the count-up or count-down operation is performed in accordance with the UP/DOWN signal produced by the phase comparator circuit 36 based on the result of comparison. The decoder 48 raises one of the outputs to H and reduces the other outputs to L in accordance with the output of the up/down counter 47. In the case where the up/down counter 47 counts up, the output position of H is shifted rightward, while when the up-down counter 47 counts down, the output position of H is shifted leftward. The output of the decoder 48 is connected to the other input terminal of each of the AND gates 43-1, 43-2,..., 43-n. Only those AND gates which are impressed with a H signal from the decoder 48 are turned on. The signal input to the AND gate thus turned on among all the outputs of the inverter string is output as an internal clock CLK2. Since the number of stages of the inverter string through which the signal passes is varied depending on the AND gates turned on, the amount of delay of the internal clock can be selected.

As described above, the delay circuits 31 and 34 are adapted to select the amount of delay in steps under the control of the delay control circuit 37. In addition, the amount of delay is the same for the delay circuits 31 and 34. Also, the buffer circuits 32 and 35 have the same configuration, so that the delay amount through the delay circuit 31 and the buffer circuit 32 is identical to the delay amount through the delay circuit 34 and the buffer circuit 35. The phase comparator circuit 36 compares the output of the buffer circuit 35 with the first internal clock CLK1 input to the delay circuit 31, and outputs an up/down signal to the delay control circuit 37 in accordance with the result of comparison. Specifically, when the phase of the first internal clock CLK1 is delayed behind the phase of the output of the buffer circuit 35, the up/down signal is raised to H thereby to increase the amount of delay through the delay circuits 31 and 34. In the case where the phase of the first internal clock CLK1 is in advance of the phase of the output of the buffer circuit 35, in contrast, the up/down signal is reduced to L thereby to reduce the amount of delay through the delay circuits 31 and 34. This process is repeated until the phase of the first internal clock CLK1 comes to coincide with the phase of the output of the buffer circuit 35. As described above, the delay amount in the delay circuit 31 and the buffer circuit 32 is identical to that in the delay circuit 34 and the buffer circuit 35. When they are in phase with each other, therefore, the output of the buffer 32 is 180° out of phase with the first internal clock CLK1.

The buffer 33 has the same configuration and the same delay amount as the buffer 32. The 1/2 phase shift clock φ 1/2 produced by the buffer 33 is in phase with the output of the buffer 32. Specifically, the signal φ 1/2 is 180° out of phase with the first internal clock CLK1.

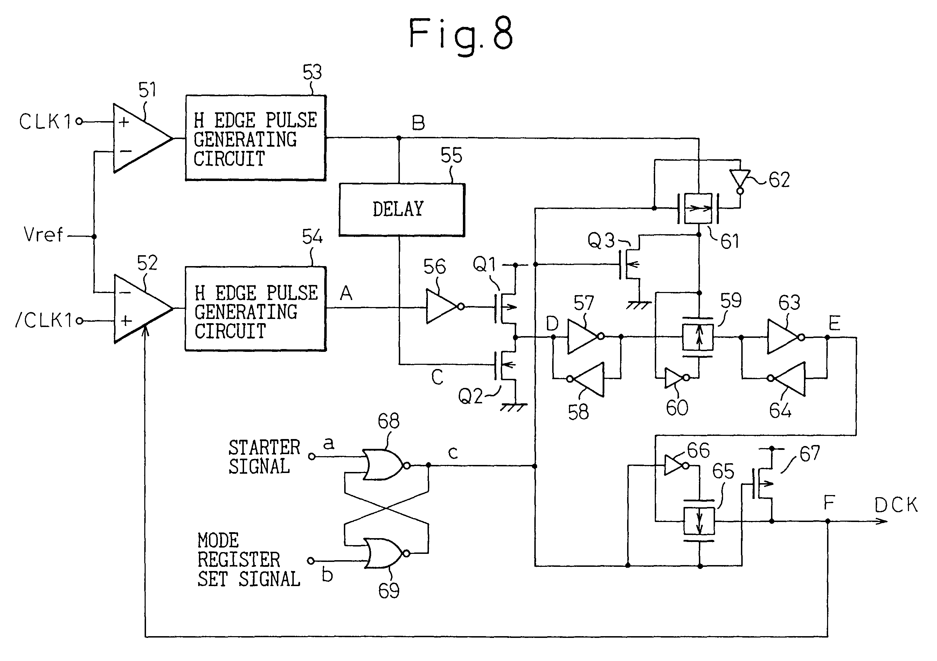

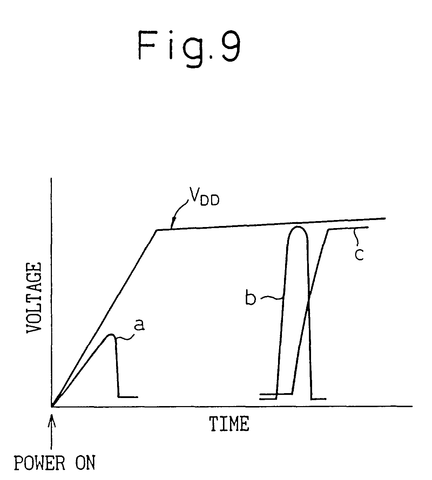

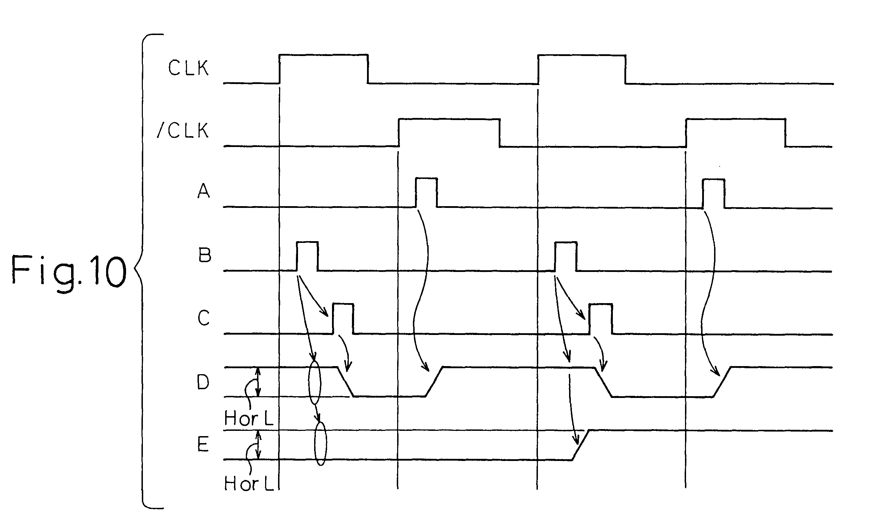

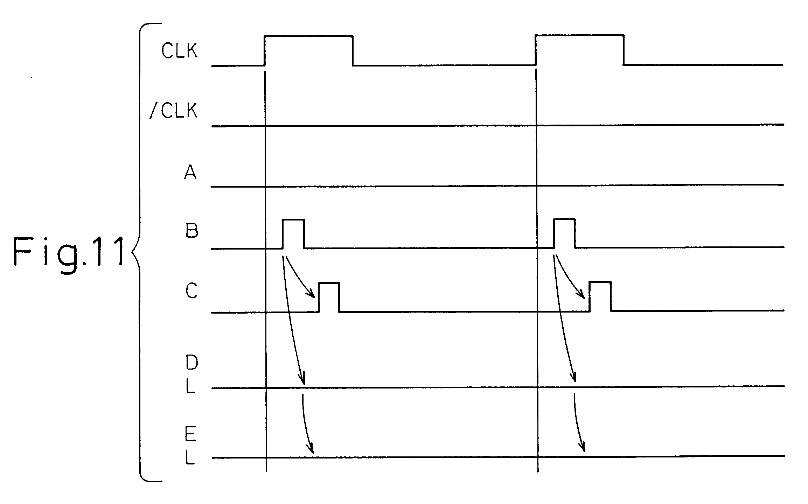

Fig. 8 is a diagram showing a circuit configuration of a /CLK state detection circuit according to the first embodiment, Fig. 9 is a diagram showing control signals for the same circuit, Fig. 10 is a time chart showing the circuit operation with the second external clock /CLK applied thereto, and Fig. 11 is a time chart showing the circuit operation in the absence of the second external clock /CLK applied thereto.

As power is switched on, the NOR gates 68 and 69 are supplied with a starter signal a and a mode register set signal b as shown in Fig. 9. Accordingly, after the lapse of a predetermined time following the power on, a state latch signal c rises and closes a transfer gate 59. The logical value of the flip-flop configured of inverters 63 and 64 is held, while at the same time opening the transfer gate 65, thereby the logical value of the flip-flop configured of the inverters 63 and 64 is output. Also, with the rise of the state latch signal c, the buffer 52 is turned off, so that the state of the second external clock /CLK is detected before the rise of the state latch signal c and subsequently the detected result is held.

As shown in Figs. 8 and 10, two buffers 51 and 52 are supplied with the first and second internal clocks CLK1 and /CLK1 output from the first and second clock input buffers 11 and 12, respectively. The outputs of the buffers 51 and 52 are applied to H edge pulse generating circuits 53 and 54, respectively. The H edge pulse generating circuit 53 generates a pulse in accordance with the leading edge of the first external clock. This pulse is applied to a transistor Q2 after being delayed in a delay line 55, reduces the input to the flip-flop made up of the inverters 57 and 58 to L, and stores the logical state thereof. When the second external clock is applied (active), the H edge pulse generating circuit 54 generates a pulse and turns on the transistor Q1. The input to the flip-flop configured of the inverters 57 and 58, therefore, rises to H, so that the logical state of the flip-flop undergoes a change. When the first external clock rises again and the H edge pulse generating circuit 53 generates a pulse, the transfer gate 59 is opened through the transfer gate 61. Accordingly, the logical state stored in the flip-flop including the inverters 57 and 58 is transferred to and stored in the flip-flop including the inverters 63 and 64. As described above, the pulse generated by the H edge pulse generating circuit 53 is delayed by the delay line 55 and then applied to the gate of the transistor Q2 thereby to turn on the transistor Q2. Thus the input to the flip-flop including the inverters 57 and 58 changes the state to L. Since the transfer gate 59 is already closed, however, the logical state is not transferred to the next stage, but the flip-flop configured of the inverters 63 and 64 maintains the particular logical state. The same operation is repeated. As long as the second external clock is changed and a pulse is generated, therefore, the logical state of the flip-flop including the inverters 63 and 64 remains H. As described above, with the rise of the state latch signal signal c after the lapse of a predetermined time following switching on power, the prevailing state is stored and maintained. Once the second external signal is input, therefore, the judge signal DCK rises to H and maintains the same state.

In the case where the second external clock is not input (inactive), as shown in Fig. 11, the H edge pulse generating circuit 54 fails to generate a pulse. The input to the flip-flop including the inverters 57 and 58, therefore, remains L and the logical state also remains unchanged. Consequently, the logical state of the flip-flop including the inverters 63 and 64 remains L. This state is stored and maintained in accordance with the rise of the state latch signal c. The judge signal DCK, therefore, is reduced to L.

The /CLK state detection circuit 21 judges whether the second external clock is input or not in the manner described above. In the case where it is input, the switch 23 is operated in such a manner that the second clock CLK2 output from the second clock input buffer 12 is produced as the second internal clock /CLK1, while at the same time turning off the switch 24. In the case where the second external clock is not input, on the other hand, the switch 23 is operated in such a manner that the 1/2 phase shift clock φ 1/2 output from the 1/2 phase shift DLL circuit 22 is produced as the second internal clock /CLK1, while at the same time closing the switch 24.

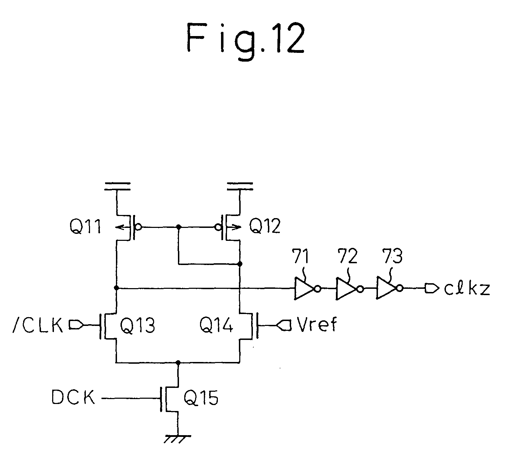

Fig. 12 is a diagram showing an example configuration of an input circuit constituting a second clock input buffer 12. An input buffer is configured by adding to this input circuit an ESD circuit or the like for improving the breakdown voltage against static electricity. As shown in Fig. 12, this input circuit includes a current mirror circuit. This circuit is widely used and will not be described in detail. The gate of a transistor Q15 is supplied with a judge signal DCK. When this judge signal DCK is L, i.e., when the second external clock fails to be input, the input circuit is turned off. The current mirror circuit allows a current to flow therethrough regardless of whatever the input signal state is, and therefore consumes considerable power. When not used, therefore, the current mirror circuit is turned off to reduce power consumption.

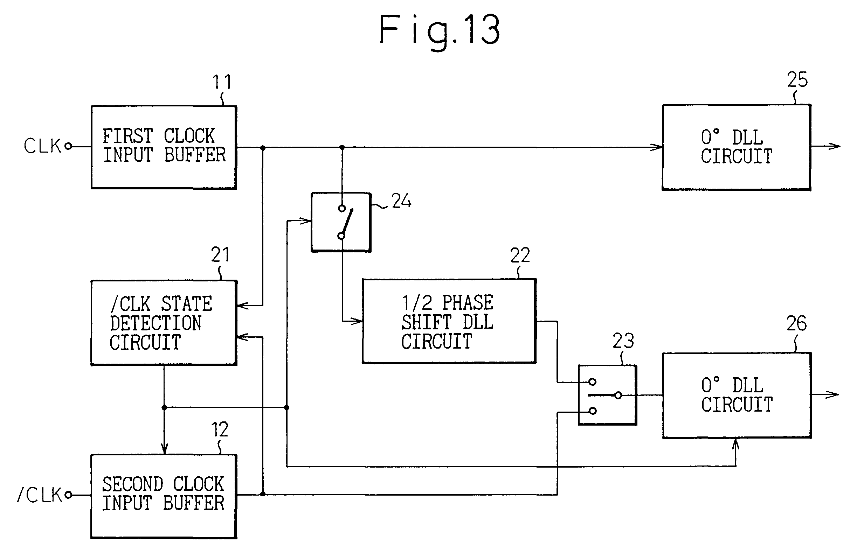

Fig. 13 is a diagram showing a configuration of an internal clock generating circuit of a semiconductor device according to a second embodiment of the invention. As shown in Fig. 13, the second embodiment is different from the first embodiment in that 0° DLL circuits 25 and 26 are newly added. Further, the /CLK state detection circuit 21 is different from the /CLK state detection circuit in the first embodiment. Only these differences will be explained.

When an internal clock is generated from an external clock, a delay occurs through a clock input buffer and an internal clock generating circuit. A delay is also caused by a signal route from the clock input buffer to the internal clock generating circuit. In the case where the clock frequency is not very high, this delay poses substantially no problem. A very high clock frequency, however, is a great problem. In view of this, the internal clock generating circuit includes a DLL circuit or a PLL circuit to generate an internal clock in phase with the external clock. Specifically, a dummy circuit is provided for causing the same delay as in the clock input buffer and the internal clock generating circuit and causing the same delay as in the signal route from the clock input buffer to the internal clock generating circuit, using the DLL circuit as shown in Figs. 6 and 7. The phase of the output of the delay circuit that has passed through this dummy circuit is compared with the phase of the internal clock, and both are controlled to coincide with each other. An internal clock-having the same phase as the external clock thus is generated. This circuit will hereinafter be called a 0° DLL circuit, and can be realized also by a PLL circuit.

As shown in Fig. 13, according to the second embodiment, the 0° DLL circuit 25 adjusts the phase of the signal output from the first clock input buffer 11 and thus generates a first internal clock CLK1 exactly in phase with the first external clock CLK, and the 0° DLL circuit 26 adjusts the phase of the output signal of a switch 23. In this way, a second internal clock /CLK1 exactly in phase with the second external clock /CLK is generated.

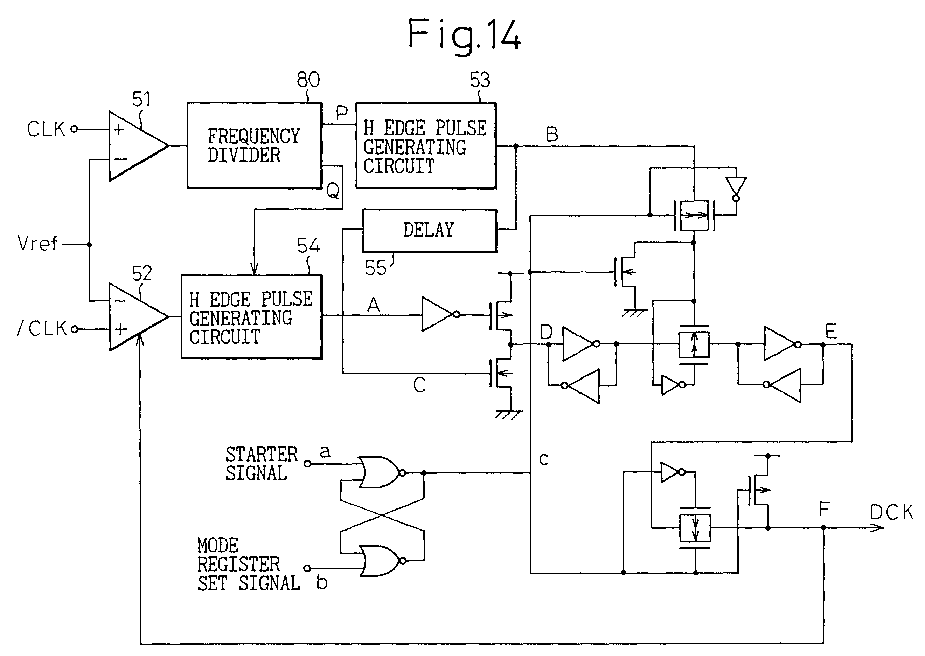

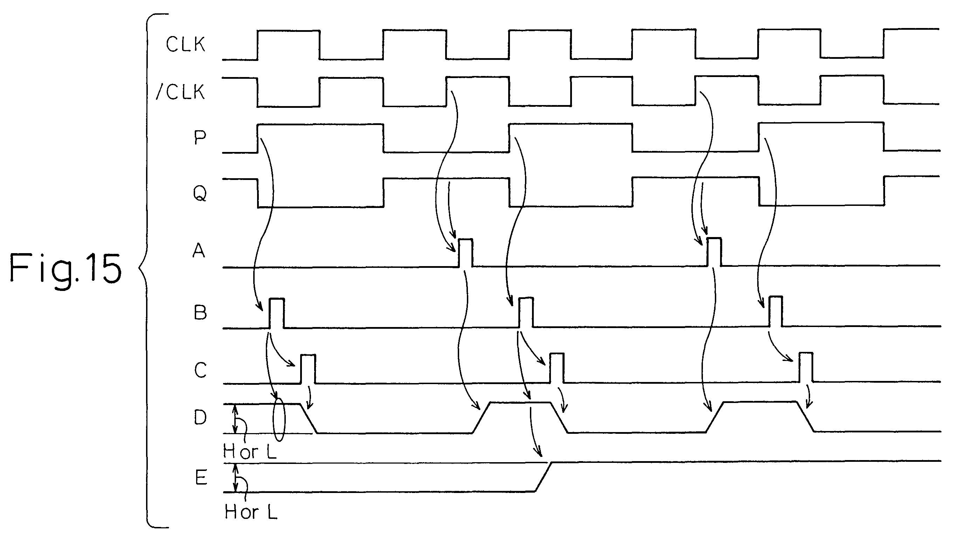

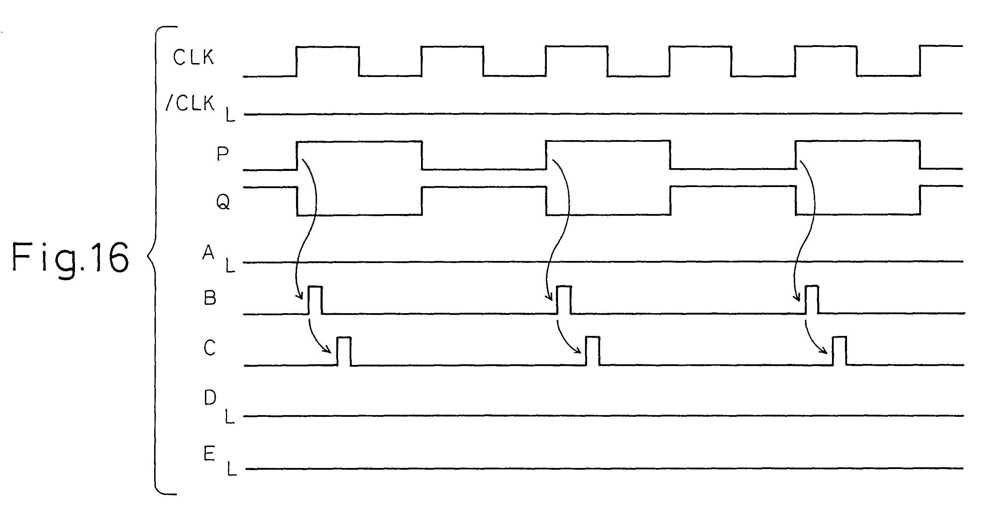

Fig. 14 is a diagram showing a configuration of a /CLK state detection circuit according to the second embodiment. As shown in Fig. 14, this configuration is the same as that of the /CLK state detection circuit in the first embodiment of Fig. 7 except that a frequency divider 80 is added. Figs. 15 and 16 are time charts showing the operation of the /CLK state detection circuit according to the second embodiment. Specifically, Fig. 15 represents the operation performed when the second external clock is input, whereas Fig. 16 refers to the operation in which the second external clock is input. An example of 1/2 frequency division is shown in the present case.

The frequency divider 80 divides the frequency of the output of the buffer 51 and produces signals P and Q complementary with each other. The period of the pulse generated in the H edge pulse generating circuit 53, therefore, is double that of the first embodiment. The H edge pulse generating circuit 54 is turned on only when the signal Q output from the frequency divider 80 is H. As a result, the period of the pulse generated in the H edge pulse generating circuit 54 is the same as in the first embodiment. After a pulse is generated in the H edge pulse generating circuit 54, a pulse is generated in the H edge pulse generating circuit 53 at the same timing as in the first embodiment. This pulse group thus performs the same operation as in the first embodiment. The same detection operation, therefore, is accomplished as in the first embodiment. Thus the signal for state detection is reduced in frequency, thereby making it possible to detect the state of /CLK easily.

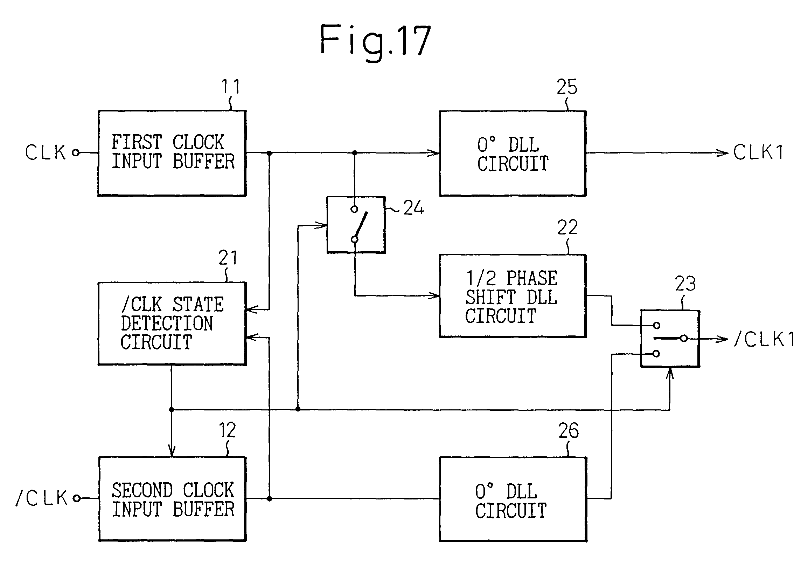

Fig. 17 is a diagram showing a configuration of an internal clock generating circuit of a semiconductor device according to a third embodiment of the invention. As shown in Fig. 17, according to the third embodiment, a 0° DLL circuit 26 is inserted after the second clock input buffer 12 unlike in the second embodiment. The other configuration is the same as in the second embodiment and will not be described.

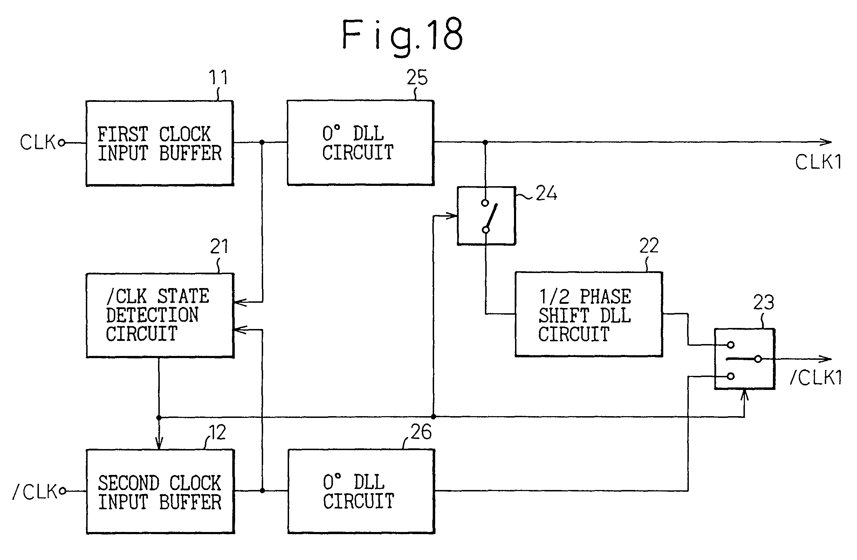

Fig. 18 is a diagram showing a configuration of an internal clock generating circuit of a semiconductor device according to a fourth embodiment. As shown in Fig. 18, the fourth embodiment is identical to the third embodiment except that an exactly phase-adjusted first internal clock output from the 0° DLL circuit 25 is applied through the switch 24 to the 1/2 phase shift DLL circuit 22, and therefore will not be described any further.

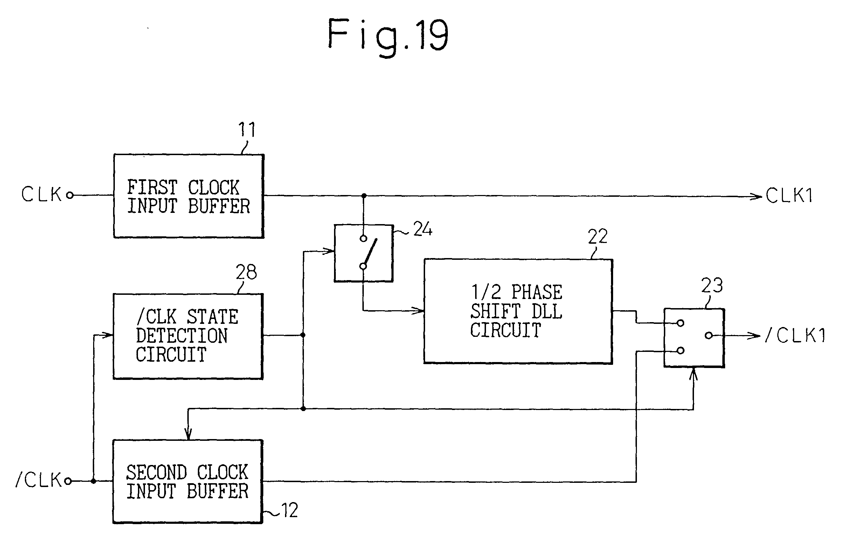

Fig. 19 is a diagram showing a configuration of an internal clock generating circuit of a semiconductor device according to a fifth embodiment of the invention. The fifth embodiment relates to a circuit for the SSTL standard providing an high-speed interface with a small-amplitude signal. In SSTL, the active signal has an amplitude which changes by ±0.2 V in both directions with respect to a reference voltage Vref. As shown in Fig. 19, the circuit according to the fifth embodiment, which has substantially the same configuration as that of the first embodiment, is different in the /CLK state detection circuit 28. The /CLK state detection circuit 28 detects the state of a second clock input pin supplied with a second external clock /CLK and judges whether the second external clock is input or not.

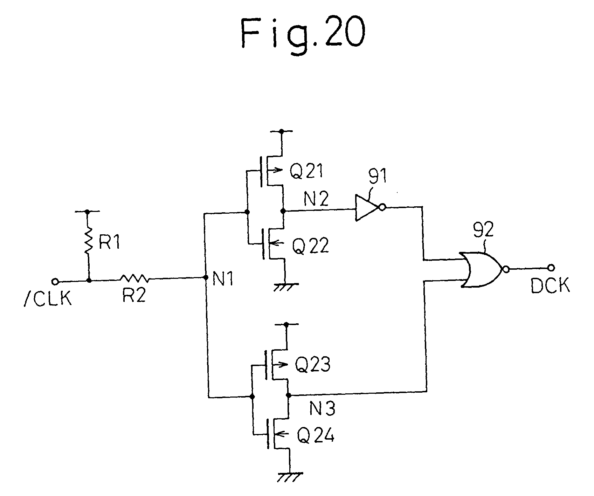

Fig. 20 is a diagram showing a configuration of a /CLK state detection circuit 28 according to the fifth embodiment. As shown in Fig. 20, a resistor R1 is inserted between a second clock input pin and a high-voltage power terminal Vcc. A P-channel transistor Q21 and a N-channel transistor Q22 are inserted in series between the high-voltage power terminal Vcc and the low-voltage power terminal Vss, thereby constituting a first inverter. Also, a P-channel transistor Q23 and a N-channel transistor Q24 are connected in series between the high-voltage power terminal Vcc and the low-voltage power terminal Vss to constitute a second inverter. The gate of each transistor is connected to the second clock input pin through a resistor R2. The output of the first inverter is inverted by the inverter 91 and applied to a NOR gate 92, while the output of the second inverter is directly applied to the NOR gate 92.

The size (gate width) of the P-channel transistor Q21 making up the first inverter is sufficiently large as compared with that of the N-channel transistor Q22. Also, the size of the N-channel transistor Q24 making up the second inverter is sufficiently larger than that of the P-channel transistor Q23. Upon application of the second external clock to the second clock input pin, a node N1 assumes an intermediate level. Then, the output of the first inverter (node N2) assumes a H state in view of the fact that the size of the P-channel transistor Q21 is sufficiently larger than the size of the N-channel transistor Q22. In similar fashion, since the size of the N-channel transistor Q24 is sufficiently larger than the size of the P-channel transistor Q23, the output of the second inverter (node N3) assumes a L state. The judge signal DCK thus assumes a H state.

When the potential of the second clock input pin is Vcc, the node N1 also assumes Vcc. Both the nodes N2 and N3 are reduced to L, and the judge signal DCK assumes an L state. When the second clock input pin assumes a potential Vss, on the other hand, the node N1 also assumes Vss, so that both the nodes N2 and N3 assume a H state, with the judge signal DCK assuming a L state. Further, when the second clock input pin is open, the node N1 assumes Vcc and therefore the judge signal DCK is L. In this way, the judge signal DCK assumes a H state when the second external clock is input, and a L state otherwise.

It will thus be understood from the foregoing description that a semiconductor device according to the present invention can be used with both a system of a type using a complementary clock and a system of a type generating a 180° phase signal internally, and therefore is not required to have different specifications for the two different types of the system. Manufacturers producing this semiconductor, therefore, can improve the production efficiency and can control the inventory more easily for a lower cost. Also, since the component parts can be shared, system manufacturers using such a semiconductor device can enjoy an easier inventory control and a lower cost.

## Claims

1. A semiconductor device having a first clock terminal and a second clock terminal, comprising:
a first clock input circuit (11) connected with the first clock terminal and producing a first internal clock (CLK1);
a second clock input circuit (12) connected with the second clock terminal and producing a second internal clock complementary with the first internal clock (CLK1) when an external clock signal (/CLK) is applied to the second clock terminal;
a 1/2 phase shift circuit (22) for generating a 1/2 phase shift signal 180° out of phase with said first internal clock (CLK1);
a detection circuit (21) for judging whether said external clock signal (/CLK) is applied to said second clock terminal; and
a switch (23) connected to an output of the second clock input circuit (12) and an output of the 1/2 phase shift circuit (22), and selecting one of the second internal clock and the 1/2 phase shift signal in response to a detection signal from the detection circuit (21).

2. A semiconductor device according to claim 1, wherein said second clock input circuit (12) is turned off when said external clock signal (/CLK) is not input.

3. A semiconductor device according to claim 1 or 2, wherein said 1/2 phase shift circuit (22) is turned off when said external clock signal (/CLK) is input.

4. A semiconductor device according to any one of claims 1 to 3, wherein said 1/2 phase shift circuit (22) includes a delay locked loop (DLL) circuit having a delay line which can select the amount of delay with a predetermined delay amount as a unit.

5. A semiconductor device according to any one of claims 1 to 4,
wherein said detection circuit (21) is adapted to detect a switching edge of said external clock signal (/CLK) and judges that said external clock signal is input upon detection of the switching thereof.

6. A semiconductor device according to claim 5,
wherein said detection circuit (21) includes a frequency divider for detecting a switching edge of said external clock signal (/CLK) with a period longer than the period of said external clock signal.

7. A semiconductor device according to any one of claims 1 to 4,
wherein said detection circuit (21) judges that said external clock signal (/CLK) is not input upon detection of a selected one of the fact that the voltage of an input pin supplied with said external clock signal is fixed to Vcc or Vss and the fact that said input pin is open.

8. A semiconductor device according to any one of claims 1 to 7,
wherein said detection circuit (21) detects whether said external clock signal (/CLK) is input during a predetermined length of time after power is turned on, and maintains the judgement subsequently.

9. A semiconductor device according to any one of claims 1 to 7,
wherein said detection circuit (21) constantly detects whether said external clock signal (/CLK) is input or not.

10. A semiconductor device according to claim 1, further comprising:
a first 0° phase adjusting circuit (25) for adjusting said first internal clock (CLK1) to be in phase with a clock signal (CLK) inputted to said first clock terminal; and
a second 0° phase adjusting circuit (26) for adjusting said second internal clock to be in phase with said external clock signal (/CLK).

## Patentansprüche

1. Halbleitervorrichtung mit einem ersten Taktanschluß und einem zweiten Taktanschluß, umfassend:
einen ersten Takteingabeschaltkreis (11), welcher mit dem ersten Taktanschluß verbunden ist, und einen ersten internen Takt (CLK1) erzeugt;
einen zweiten Takteingabeschaltkreis (12), welcher mit dem zweiten Taktanschluß verbunden ist und einen zweiten internen Takt erzeugt, welcher zu dem ersten interne Takt (CLK1) komplementär ist, wenn ein externes Taktsignal (/CLK) an den zweiten Taktanschluß angelegt wird;
einen 1/2-Phasen-Verschiebungsschaltkreis (22) zum Erzeugen eines 1/2-Phasen-Verschiebungssignals um 180° außer Phase mit dem ersten internen Takt (CLK1);
einen Detektierschaltkreis (21) zum Entscheiden, ob das externe Taktsignal (/CLK) an den zweiten Taktanschluß angelegt ist; und
einen Schalter (23), welcher mit einem Ausgang des zweiten Takteingabeschaltkreises (12) und einem Ausgang des 1/2-Phasen-Verschiebungsschaltkreises (22) verbunden ist und welcher eines von beiden, nämlich das zweite interne Taktsignal bzw. das 1/2-Phasen-Verschiebungssignal in Reaktion auf ein Detektiersignal von dem Detektierschaltkreis (21) auswählt.

2. Halbleitervorrichtung nach Anspruch 1, bei welcher der zweite Takteingabeschaltkreis (12) abgeschaltet wird, wenn das externe Taktsignal (/CLK) nicht eingegeben wird.

3. Halbleitervorrichtung nach Anspruch 1 oder 2, bei welcher der 1/2-Phasen-Verschiebungsschaltkreis (22) abgeschaltet wird, wenn das externe Taktsignal (/CLK) eingegeben wird.

4. Halbleitervorrichtung nach einem der Ansprüche 1 bis 3, bei welcher der 1/2-Phasen-Verschiebungsschaltkreis (22) einen verzögerungsverriegelten Schleifen(DLL)-Schaltkreis mit einer Verzögerungsleitung umfaßt, die den Verzögerungsbetrag mit einem vorgegebenen Verzögerungsbetrag als Einheit auswählen kann.

5. Halbleitervorrichtung nach einem der Ansprüche 1 bis 4, bei welcher der Detektierschaltkreis (21) dazu ausgelegt ist, eine Schaltflanke des externen Taktsignals (/CLK) zu detektieren, und beim Detektieren des Schaltens derselben entscheidet, daß das externe Taktsignal eingegeben ist.

6. Halbleitervorrichtung nach Anspruch 5, bei welcher der Detektierschaltkreis (21) einen Frequenzteiler zum Detektieren einer Schaltflanke des externen Taktsignals (/CLK) mit einer Periode, die länger als die Periode des externen Taktsignals ist, umfaßt.

7. Halbleitervorrichtung nach einem der Ansprüche 1 bis 4, bei welcher der Detektierschaltkreis (21) beim Detektieren einer ausgewählten Tatsache, nämlich der Tatsache, daß die Spannung eines mit dem externen Taktsignal versorgten Eingabepins auf Vcc oder Vss festgelegt ist, bzw. der Tatsache, daß dieser Eingabepin offen ist, entscheidet, daß das externe Taktsignal (/CLK) nicht eingegeben ist.

8. Halbleitervorrichtung nach einem der Ansprüche 1 bis 7, bei welcher der Detektierschaltkreis (21) detektiert, ob das externe Taktsignal (/CLK) während einer vorgegebenen Zeitspanne nach Einschalten des Stromes eingegeben worden ist, und anschließend die Entscheidung festhält.

9. Halbleitervorrichtung nach einem der Ansprüche 1 bis 7, bei welcher der Detektierschaltkreis (21) ständig detektiert, ob das externe Taktsignal (/CLK) eingegeben worden ist oder nicht.

10. Halbleitervorrichtung nach Anspruch 1, ferner umfassend:
einen ersten 0°-Phasen-Justierschaltkreis (25), um den ersten internen Takt (CLK1) in Phase mit einem Taktsignal (CLK) zu justieren, das in den ersten Taktanschluß eingegeben wurde; und
einen zweiten 0°-Phasen-Justierschaltkreis (26), um den zweiten internen Takt in Phase mit dem externen Taktsignal (/CLK) zu justieren.

## Revendications

1. Dispositif à semiconducteur comportant une première borne d'horloge et une seconde borne d'horloge, comprenant :
un premier circuit d'entrée d'horloge (11) relié à la première borne d'horloge et produisant une première horloge interne(CLK1),
un second circuit d'entrée d'horloge (12) relié à la seconde borne d'horloge et produisant une seconde horloge interne complémentaire de la première horloge interne (CLK1) lorsqu'un signal d'horloge externe (/CLK) est appliqué à la seconde borne d'horloge,
un circuit de déphasage 1/2 (22) destiné à générer un signal de déphasage 1/2 déphasé de 180° par rapport à ladite première horloge interne (CLK1),
un circuit de détection (21) destiné à évaluer si ledit signal d'horloge externe (/CLK) est appliqué à ladite seconde borne d'horloge, et
un commutateur (23) relié à une sortie du second circuit d'entrée d'horloge (12) et à une sortie du circuit de déphasage 1/2 (22) et sélectionnant l'un de la seconde horloge interne et du signal déphasé de 1/2 en réponse en un signal de détection provenant du circuit de détection (21).

2. Dispositif à semiconducteur selon la revendication 1, dans lequel ledit second circuit d'entrée d'horloge (12) est désactivé lorsque ledit signal d'horloge externe (/CLK) n'est pas appliqué en entrée.

3. Dispositif à semiconducteur selon la revendication 1 ou 2, dans lequel ledit circuit de déphasage 1/2 (22) est désactivé lorsque ledit signal d'horloge externe (/CLK) est appliqué en entrée.

4. Dispositif à semiconducteur selon l'une quelconque des revendications 1 à 3, dans lequel ledit circuit de déphasage 1/2 (22) comprend un circuit de boucle à retard verrouillé (DLL) présentant une ligne à retard qui permet de sélectionner la quantité de retard avec une quantité de retard prédéterminée en tant qu'unité.

5. Dispositif à semiconducteur selon l'une quelconque des revendications 1 à 4,
dans lequel ledit circuit de détection (21) est conçu pour détecter un front de commutation dudit signal d'horloge externe (/CLK) et à évaluer que ledit signal d'horloge externe est appliqué en entrée lors de la détection de la commutation de celui-ci.

6. Dispositif à semiconducteur selon la revendication 5,
dans lequel ledit circuit de détection (21) comprend un diviseur de fréquence destiné à détecter un front de commutation dudit signal d'horloge externe (/CLK) présentant une période plus longue que la période dudit signal d'horloge externe.

7. Dispositif à semiconducteur selon l'une quelconque des revendications 1 à 4,
dans lequel ledit circuit de détection (21) évalue que ledit signal d'horloge externe (/CLK) n'est pas appliqué en entrée lors de la détection d'un fait sélectionné parmi le fait que la tension d'une broche d'entrée recevant ledit signal d'horloge externe est fixée à Vcc ou Vss et le fait que ladite broche d'entrée est ouverte.

8. Dispositif à semiconducteur selon l'une quelconque des revendications 1 à 7,
dans lequel ledit circuit de détection (21) détecte si le signal d'horloge externe (/CLK) est appliqué en entrée durant un intervalle de temps prédéterminé après la mise sous tension et conserve l'évaluation par la suite.

9. Dispositif à semiconducteur selon l'une quelconque des revendications 1 à 7,
dans lequel ledit circuit de détection (21) détecte constamment si ledit signal d'horloge externe (/CLK) est appliqué en entrée ou non.

10. Dispositif à semiconducteur selon la revendication 1, comprenant en outre :
un premier circuit d'ajustement de phase à 0° (25) destiné à ajuster ladite première horloge interne (CLK1) pour qu'elle soit en phase avec un signal d'horloge (CLK) appliqué en entrée à ladite première borne d'horloge, et
un second circuit d'ajustement de phase à 0° (26) destiné à ajuster ladite seconde horloge interne pour qu'elle soit en phase avec ledit signal d'horloge externe (/CLK).
